Europäisches Patentamt

European Patent Office

Office européen des brevets

(11) Numéro de publication: **0 269 522**
**A1**

## (12) DEMANDE DE BREVET EUROPEEN

(21) Numéro de dépôt: 87402643.8

(51) Int. Cl.⁴: **H 01 R 13/24**

(22) Date de dépôt: 24.11.87

(30) Priorité: 26.11.86 FR 8616474

(43) Date de publication de la demande:
01.06.88 Buiietin 88/22

(84) Etats contractants désignés: **DE ES GB IT**

(71) Demandeur: **JAEGER**
**2, rue Baudin**
**F-92303 Levallois-Perret (FR)**

(72) Inventeur: **Granger, Jacques**
**1, rue Edouard Branly**
**F-78400 Chatou (FR)**

(74) Mandataire: **Martin, Jean-Jacques et al**
**Cabinet REGIMBEAU 26, Avenue Kléber**
**F-75116 Paris (FR)**

(54) Dispositif de connexion électrique, en particulier pour afficheurs à cristaux liquides.

(57) La présente invention concerne un dispositif de connexion électrique entre deux systèmes, du type comprenant un élément de connexion (152) comportant un empilement de couches de caoutchouc alternativement électriquement isolantes et conductrices. Selon l'invention l'élément est constitué d'une barrette allongée comprenant une âme (154) en caoutchouc électriquement isolant, de section droite oblongue, revêtue sur au moins deux faces orthogonales d'une peau de recouvrement (156), continue dans le sens de la longueur, d'un empilement de couches de caoutchouc alternativement isolantes et conductrices, dans lequel l'âme (154) possède une duret& inférieure à la peau de recouvrement (165).

FIG. 3

EP 0 269 522 A1

## Description

DISPOSITIF DE CONNEXION ELECTRIQUE, EN PARTICULIER POUR AFFICHEURS A CRISTAUX LIQUIDES.

La présente invention concerne le domaine des dispositifs de connexion électrique.

La présente invention trouve application, notamment mais non exclusivement, dans l'alimentation des afficheurs à cristaux liquides.

La présente invention a pout but principal de proposer un dispositif de connexion électrique permettant de relier électriquement deux systèmes généralement plans, d'orientations orthogonales tels qu'un afficheur à cristaux liquides et un circuit imprimé.

Un autre but de la présente invention est de proposer un dispositif de connexion assurant une sollicitation élastique sur les systèmes à relier afin de maintenir une liaison électrique permanente entre ceux-ci, même si l'ensemble est soumis à des vibrations mécaniques.

Un autre but de la présente invention est de proposer un dispositif de connexion électrique assurant une sollicitation élastique sur l'un au moins des systèmes à relier, pour participer au maintien de celui-ci.

Le dispositif de connexion électrique conformme à la présente invention comprend un élément de connexion comportant un empilement de couches de caoutchouc alternativement isolantes et conductrices, adapté pour assurer une liaison électrique avec les systèmes à relier, respectivement au niveau de deux faces orthogonales.

On a déjà proposé des dispositifs de connexion comprenant un tel élément.

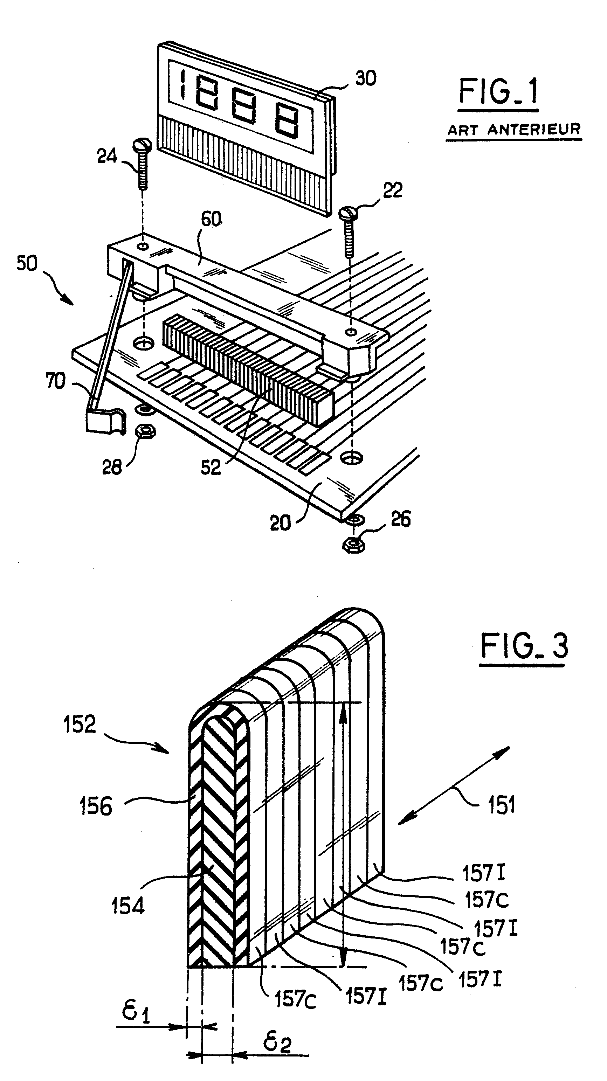

La structure des dispositifs de connexion de ce type, jusqu'ici proposés, est illustrée sur la figure 1 annexée.

On aperçoit sur la figure 1 un circuit imprimé 20 et un afficheur à cristaux liquides 30 qui doivent être reliés électriquement.

Le dispositif de connexion 50 comprend un support rigide 60, une mâchoire élastique 70 et l'élément de connexion 52.

Le support rigide 60 est fixé sur le circuit imprimé 20 par deux vis de fixation 22, 24 venant en prise avec deux écrous 26, 28. Le support rigide 60 comprime l'élément 52 selon une première direction.

La mâchoire élastique 70 est maintenue par encliquetage sur le support rigide 60. Elle comprime l'élément 52 selon une seconde direction et permet la fixation mécanique de l'afficheur 30 en pinçant celui-ci. Les dispositifs du type illustré sur la figure 1 ont rendu de grands services. Néanmoins, ils ne donnnent pas entière satisfaction.

Ces dispositifs sont en effet coûteux. De plus, leur mise en place est délicate et fastidieuse en raison notamment du vissage pour assurer la fixation du support 60 et l'encliquetage de la mâchoire élastique 70 sur ce dernier. En outre, la fiabilité des dispositifs illustrés sur la figure 1 laissent parfois à désirer, notamment dans le cadre d'utilisations soumises à vibrations.

Les documents US-A-4 598 960 et US-A-4 204 205 évoquent d'autres variantes d'utilisation d'un élément connu de connexion comportant un empilement de couches de caoutchouc alternativement isolantes et conductrices.

Le document EO-A-0 168 227 décrit un dispositif de connexion électrique comprenant un empilement de couches de caoutchouc alternativement électriquement isolantes et conductrices, disposées sous forme de deux sections orthogonales en L, et un élément électriquement isolant placé sur la surface interne de l'une des sections, à distance de l'autre, pour ménager une rainure entre l'élément électriquement isolant et cette dernière section.

La présente invention vient maintenant améliorer la situation en proposant un dispositif de connexion électrique entre deux systèmes, du type comprenant un élément de connexion comportant un empilement de couches de caoutchouc alternativement électriquement isolantes et conductrices caractérisé par le fait que l'élément est constitué d'une barrette allongée comprenant une âme en caoutchouc électriquement isolant, de section droite oblongue, revêtue sur au moins trois faces d'une peau de recouvrement continue et de section droite en forme de U constituée, dans le sens de la longueur de la barrette, d'un empilement de couches de caoutchouc alternativement isolantes et conductrices, dans lequel l'âme possède une dureté inférieure à la peau de recouvrement.

Selon une caractéristique avantageuse de la présente invention, le dispositif de connexion comprend en outre un support rigide adapté pour être fixé sur l'un des éléments à relier et possédant une feuilleure adaptée pour recevoir l'élément de connexion tout en assurant une sollicitation sur celui-ci selon deux directions orthogonales.

De préférence, le support rigide est muni sur l'une des faces de la feuillure d'une nervure qui repose contre l'élément pour solliciter celui-ci contre l'un des systèmes à relier.

D'autres caractéristiques, buts et avantages de la présente invention apparaîtront à la lecture de la descripion détaillée qui va suivre et en regard des dessins annexés donnés à titre d'exemples non limitatifs et sur lesquels, la figure 1 qui illustre l'art antérieur ayant déjà été décrite :
- la figure 2 représente une vue schématique en coupe d'un dispositif de connexion conforme à la présente invention,
- la figure 3 représente une vue schématique en coupe, à échelle agrandie, d'un élément de connexion incorporé au dispositif de connexion conforme à la présente invention, et
- la figure 4 représente une vue schématique en coupe d'un système d'affichage incorporant le dispositif de connexion électrique conforme à la présente invention.

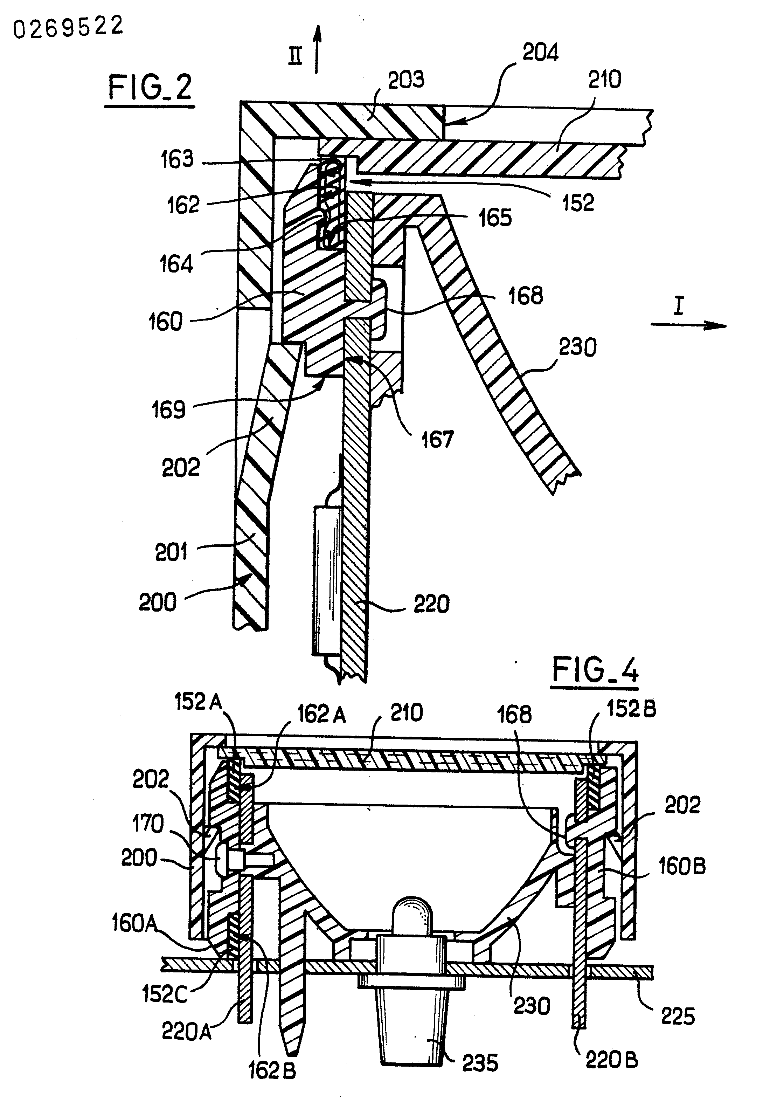

On aperçoit sur la figure 2 annexée un dispositif de connexion électrique comprernant en combinaison un élément de connexion électrique 152 et un support rigide 160.

On aperçoit en outre sur la figure 2 annexée, un boîtier 200, un afficheur à cristaux liquides plan 210, un circuit imprimé 220 et une boîte à lumière 230.

L'élément de connexion 152 est représenté en échelle agrandie sur la figure 3.

L'élément de connexion 152 est constitué d'une barrette allongée comprenant une âme 154 et une peau de recouvrement 156.

L'âme 154 est réalisée en caoutchouc électriquement isolant. Elle possède une section droite oblongue

Le sens de la longueur de l'élément 152 est illustré par la flèche référencée 151 sur la figure 3.

La peau de recouvrement 156 est constituée, dans le sens de la longueur de l'élément 152, d'un empilement de couches de caoutchouc alternativement électriquement conductrices et électriquement isolantes. Sur la figure 3 on a référencé 157C les couches de la peau 156 qui sont électriquement conductrices et 157I, les couches de la peau 156 qui sont électriquement isolantes.

La peau 156 recouvre l'âme 154 sur au moins deux faces orthogonales. Plus précisément encore selon la représentation préférentielle donnée sur les figures annexées, la peau 156 recouvre l'âme 154 sur trois faces orthogonales. Ainsi, chacune des couches 157 de la peau 156 a une section droite en "U".

Selon l'invention la dureté de l'âme 154 est inférieure à la dureté de la peau de recouvrement 156.

De façon avantageuse la dureté de l'âme 154 est comprise entre 30 et 50 shores en étant de préférence de l'ordre de 40 shores, tandis que la dureté de la peau de recouvrement 156 est comprise entre 60 et 80 shores en étant de préférence de l'ordre de 70 shores.

Ainsi l'élément de connexion électrique 152 conforme à la présente invention peut, par déformation de l'âme 154, supporter des efforts de compression élevés, tout en assurant une liaison électrique parfaitement fiable avec des systèmes reposant contre cette peau 156, même si l'ensemble est soumis à des vibrations intenses et continues.

Le support rigide 160 est formé d'une barrette en matière plastique. On en voit la section droite sur la figure 2.

Le support rigide 160 comprend une feuillure 162 de section quadrangulaire destinée à recevoir l'élément 152.

Sur la figure 2 on a référencé 163 et 165 les deux faces de la feuillure 162.

Les largeurs de ces faces 163, 165 qui déterminent la hauteur et l'épaisseur de la feuillure 162 sont inférieures à la hauteur et à l'épaisseur de l'élément 152 de telle sorte que ce dernier émerge de la feuillure 162.

A l'utilisation l'une des grandes faces latérales de la peau 156 repose contre la grande face 163 de la feuillure.

La face d'extrémité de l'élément 152 qui est dépourvue de peau 156 repose contre la petite face 165 de la feuillure.

Par ailleurs, le support rigide 160 est muni sur sa grande face 163 d'une nervure longitudinale 164 qui repose contre la face latérale associée de la peau 156 pour solliciter l'élément 152 contre l'un des systèmes à relier.

Le support rigide 160 peut être fixé sur l'un des systèmes à relier 220 par tout moyen classique approprié. Selon l'illustration donnée sur la figure 2 annexée, le support rigide 160 est fixé par bouterrollage référencé 168, sur un circuit imprimé 220.

La feuillure 162 débouche sur la face 167 du dispositif rigid 160 portant les tétons de bouterrollage 168. Ainsi en position assemblée, l'élément 152 est pincé, dans le sens de son épaisseur, entre la grande face 163 de la feuillure et le circuit imprimé 220. Une sollicitation est de ce fait exercée sur l'élément de connexion 152 (dans le sens illustré par la flèche référencée I) pour garantir un contact électrique fiable entre cet élément 152 et le circuit imprimé 220.

Par ailleurs, une sollicitation est exercée sur le dispositif rigide 160 et l'élément de connexion 152 dans une seconde direction illustrée par les flèches référencées II, par des languettes 202 prévues sur le boîtier 200.

Ces languettes 202 sont solidaires des faces latérales 201 du boîtier 200. Elle s'étendent vers l'intérieur du boîtier en direction de la face avant 203 de celui-ci. Les languettes 202 viennent reposer contre une face arrière 169 du support rigide 160, opposée à celle sur laquelle débouche la feuillure 162.

Pour asembler l'ensemble illustré sur la figure 2 on procède comme suit:

L'afficheur 210 est introduit dans le boîtier 200 et vient reposer contre la face avant 203 de celui-ci, en regard d'une fenêtre 204 ménagée dans la face avant 203.

L'élément 152 est placé dans la feuillure 162 du dispositif rigide 160 et ce dernier est fixé sur le circuit imprimé 220. L'élément 152 est alors en contact électrique avec le circuit imprimé 220.

Ensuite, le circuit imprimé 220 équipé de l'élément 152 et du dispositif 160 est introduit dans le boîtier 200 et poussé en regard de l'afficheur 210. La peau de recouvrement 156 vient en contact électrique avec l'affilcheur. L'élément 152 assure l'interconnexion entre le circuit imprimé 220 et l'afficheur 210 par l'intermédiaire des couches conductrices 157 C de la peau 156. Le dispositif rigide 160, l'élément 152 et le circuit imprimé 220 sont maintenus par les languettes 202. L'élément 152 est sollicité selon la seconde direction II.

Grâce aux dispositions de la présente invention, l'afficheur 210 et le circuit imprimé 220 étant orthogonaux, on libère l'espace arrière de l'afficheur 210. Cet espace peut de ce fait recevoir un réflecteur 230 illustré schématiquement sur la figure 2 pour permettre, en association avec une source lumineuse hon représentée, un éclairage optimum de l'afficheur 210.

On va maintenant décrire le mode de réalisation illustré sur la figure 4.

On distingue sur cette figure 4 un boîtier 200, un afficheur à cristaux liquides plan 210, deux circuits imprimés 220 A et 220 B, perpendiculaires à l'afficheur 210, un circuit imprimé auxiliaire 225 parallèle à l'afficheur 210 et perpendiculaire aux circuits imprimés 220A, 220B, un réflecteur 230 placé en arrière de l'afficheur 210 entre les circuits imprimés 220 A, 220B, une source lumineuse 235 associée au réflecteur, deux éléments 152 A, 152 B assurant une interconnexion entre l'afficheur 210 et l'un des circuits imprimés 220 A ou 220 B respectivement et deux dispositifs rigides 160A, 160B, portant les éléments 152 A, 152 B respectivement.

Selon le mode de réalisation représenté sur la figure 4, le dispositif rigide 160 A comporte deux feuillures 162 A, 162 B.

La feuillure 162 A reçcoit l'élément 152 A précité qui assure une interconnexion entre le circuit 220 A et l'afficheur 210.

La feuillure 162 B reçcoit un élément de connexion auxiliaire 152 C (similaire à celui illustré sur la figure 3 qui assure une interconnexion entre les circuits imprimés 220 A et 225.

La figure 4 montre par ailleurs que les dispositifs rigides 160 A, 160 B qui exercent des sollicitations selon deux directions orthogonales sur les éléments 152 A, 152 B, 152 C, peuvent être fixés sur les circuits imprimés à l'aide de tétons 168 de rivetage ou bouterrollage, venus de moulage ou à l'aide de moyens 170 séparés. Ces derniers peuvent d'ailleurs venir en prise avec le réflecteur 230 et non point avec les circuits imprimés 220 A ou 220 B, comme illustré sur la gauche de la figure 4.

Selon un mode de réalisation préférentiel, mais non limitatif, la hauteur h de l'élément 152 est comprise entre 4 et 10 mm en étant de préférence de l'ordre de 6,5 mm, l'épaisseur $\varepsilon_1$ de la peau de recouvrement 156 est comprise entre 0,2 et 0,6mm en étant de préférence de l'ordre de 0,4mm, tandis que l'épaisseur $\varepsilon_2$ de l'âme 154 est comprise entre 0,5 et I mn en étant de préférence de l'ordre de 0,7mm.

De façon classique en soi l'élément de connexion 152 peut être réalisé en élastomère statifié du type caoutchouc silicone ou équivalent. Le pas de l'empilement des couches 157 I, 157 C est inférieur au pas des conducteurs prévus sur l'afficheur 210 et sur les circuits imprimés 220A, 220B.

Bien entendu, la présente invention n'est pas limitée aux modes de réalisation qui viennent d'être décrits mais s'étend à toute variante conforme à son esprit.

## Revendications

1. Dispositif de connexion électrique entre deux systèmes, du type comprenant un élément de connexion (152) comportant un empilement de couches de caoutchouc alternativement électriquement isolantes et conductrices, caractérisé par le fait que l'élément est constitué d'une barrette allongée comprenant une âme (154) en caoutchouc électriquement isolant, de section droite oblongue, revêtue sur au moins trois faces d'une peau de recouvrement (156), continue et de section droite en forme de U, constituée dans le sens de la longueur, d'un empilement de couches de caoutchouc alternativement isolantes et conductrices, dans lequel l'âme (154) possède une dureté inférieure à la peau de recouvrement (156).

2. Dispositif de connexion électrique selon la revendication 1, caractérisé par le fait qu'il comprend en outre un support rigide (160) adapté pour être fixé sur l'un des éléments à relier et possédant une feuillure (162) adaptée pour recevoir l'élément de connexion (152) tout en assurant une sollicitation sur celui-ci selon deux directions orthogonales.

3. Dispositif de connexion électrique selon la revendication 2, caractérisé par le fait que le support rigide (160) est muni sur l'une des faces de la feuillure (162) d'une nervure qui repose contre l'élément (152) pour solliciter celui-ci contre l'un des systèmes à relier.

4. Dispositif de connexion électrique selon l'une des revendications 1 à 3, caractérisé par le fait que la dureté de l'âme (154) est comprise entre 30 et 50 shores en étant de préférence de l'ordre de 40 shores.

5. Dispositif de connexion électrique selon l'une des revendications 1 à 4, caractérisé par le fait que la dureté de la peau de recouvrement (156) est comprise entre 60 et 80 shores en étant de préférence de l'ordre de 70 shores.

6. Dispositif de connexion électrique selon l'une des revendications 1 à 5, caractérisé par le fait que l'épaisseur ($\varepsilon_2$) de l'âme (154) est comprise entre 0,5 et 1 millimètre en étant de préférence de l'ordre de 0,7 millimètre, tandis que l'épaisseur ($\varepsilon_1$) de la peau de recouvrement (156) est de l'ordre de 0,2 à 0,6 millimètre en étant de préférence de l'ordre de 0,4 millimètre.

7. Dispositif de connexion électrique selon l'une des revendications 1 à 6, caractérisé par le fait que la hauteur (h) de l'élément (152) est comprise entre 4 et 10 mm en étant de préférence de l'ordre de 7 mm.

8. Dispositif de connexion électrique selon l'une des revendications 1 à 7 prise en combinaison avec la revendication 3, caractérisé par le fait que le support rigide (160) vient en prise avec des languettes élastiques (202) solidaires d'une paroi d'un boîtier.

0269522

FIG_1

ART ANTERIEUR

FIG_3

FIG_2

FIG_4

Office européen
des brevets

# RAPPORT DE RECHERCHE EUROPEENNE

Numero de la demande

EP 87 40 2643

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| D,Y | EP-A-0 168 227 (SHARP) <br> * Page 3, lignes 1-22; page 4, lignes 6-9; figures 1-3 * <br> --- | 1,2 | H 01 R 13/24 |
| D,Y | US-A-4 598 960 (COPYTELE) <br> * Colonne 8, lignes 34-66; figures 4,6,7 * | 1,2 | |
| D,A | | 3,8 | |
| | --- | | |
| D,A | US-A-4 204 205 (KABUSHIKI) <br> * Colonne 3, lignes 18-22; figures 2-4 * <br> ----- | 1,6,7 | |

| | DOMAINES TECHNIQUES RECHERCHES (Int. Cl.4) |
|---|---|
| | H 01 R 9/00 <br> H 01 R 13/00 <br> H 01 R 23/00 <br> H 05 K 3/00 |

**Le présent rapport a été établi pour toutes les revendications**

| Lieu de la recherche | Date d'achèvement de la recherche | Examinateur |
|---|---|---|
| LA HAYE | 05-02-1988 | CERIBELLA G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

...............................................................
& : membre de la même famille, document correspondant

EPO FORM 1503 03.82 (P0402)